# EUROPEAN PATENT APPLICATION

(11) **EP 0 780 487 A1**
(43) Date of publication of application: **25.06.1997**
(21) Application number: 96120579.6
(22) Date of filing: 20.12.1996
(51) Int. Cl.: C23C 14/35, H01J 37/34

(54) **Gasketed target assembly**

(30) Priority: 22.12.1995 US 576890
(71) Applicant: APPLIED MATERIALS, INC., Santa Clara, California 95052 (US); APPLIED KOMATSU TECHNOLOGY, INC., Shinjuku, Tokyo (JP)
(72) Inventor: Wytman, Joseph, Los Gatos, CA 95030 (US); Demaray, Richard Ernest, Portola Valley, CA 94028 (US); Herrera, Manuel, San Mateo, CA 94402 (US)
(74) Representative: Kahler, Kurt, Dipl.-Ing.

(57) **Abstract**

A target plate assembly (79, 80, 95) completely covers and seals against a top opening of a sputtering processing chamber. Cooling liquid connections are provided only from the perimeter of the target assembly. When a top vacuum chamber seals the side opposite the pressure chamber, the pressure on both sides of the target assembly is nearly equalized. Large thin target assemblies, such as large flat plates used for flat panel displays can be sputtered effectively and uniformly without adverse sputtering effects due to target deflection or cooling deficiencies. A target (79), target backing plate (80), and cover plate (95) form the target plate assembly. The sputtering target assembly includes an integral cooling passage. A series of grooves are constructed in either the target backing plate (80) or the target backing cooling cover plate (95), which are then securely bonded to one another using a gasketed configuration. The sputtering target can be a single monolith with a target backing plate or can be securely attached to the target backing plate by one of any number of conventional bonding methods.

## Description

### Field of the Invention

This invention relates to planar magnetron sputtering targets and more specifically to a structure and method for cooling the sputtering target and a structure and method for holding such a target being cooled.

### BACKGROUND OF THE INVENTION

Sputtering describes a number of physical techniques commonly used in, for example, the semiconductor industry for the deposition of thin films of various metals such as aluminum, aluminum alloys, refractory metal silicides, gold, copper, titanium-tungsten, tungsten, molybdenum, tantalum and less commonly silicon dioxide and silicon on an item (a substrate), for example a water or glass plate being processed. In general, the techniques involve producing a gas plasma of ionized gas "particles" (atoms or molecules) by imposing an electrical field across an evacuated chamber which has been at least partially backfilled with the selected gas. A portion of the gas atoms are ionized, and these ionized particles are then directed toward a "target" and collides with it. As a result of the energy of the ion-target collisions, free atoms or groups of negatively biased atoms of the target material are ejected from the surface of the target, essentially converting the target material to free atoms or molecules. Most of the free atoms which escape the target surface in the direction of the substrate strike the substrate without intervening collision and form (deposit) a thin film on the surface of the object (e.g. wafer, substrate) being processed, which is located a relatively short distance from the target.

One common sputtering technique is magnetron sputtering. When processing wafers using magnetron sputtering, a magnetic field is used to concentrate sputtering action in the region of the magnetic field so that target sputtering occurs at a higher rate and at a lower process pressure than is possible without the magnetic field. The target itself is electrically biased with respect to the wafer and chamber, and functions as a cathode. Objectives in engineering the cathode and its associated magnetic field source include uniform erosion of the target and uniform deposition of pure target material on the wafer being processed .During sputtering, if magnets generating a magnetic field are stationary at a location, then continuous sputtering quickly consumes the sputtering target thickness at that location and generates hot spots at the locations of sputtering. Therefore, the magnets are usually continuously moved over the back of the target during its sputtering. Nonetheless, non-uniform wear patterns persist. To avoid contaminating the process chamber with any material or consumable located behind the target, sputtering is stopped before the non-uniform sputtering wear pattern has consumed the full thickness of the target material at any point. If any point on the target backing plate behind the target were to be reached, sputtering of the target backing plate material (often copper) would occur, contaminating the vacuum chamber and the wafer being processed with the target backing material (e.g., copper). Because of the non-uniform pattern of target material utilization, conventional practice is to stop the sputtering while a large percentage of the target material still remains to be sputtered.

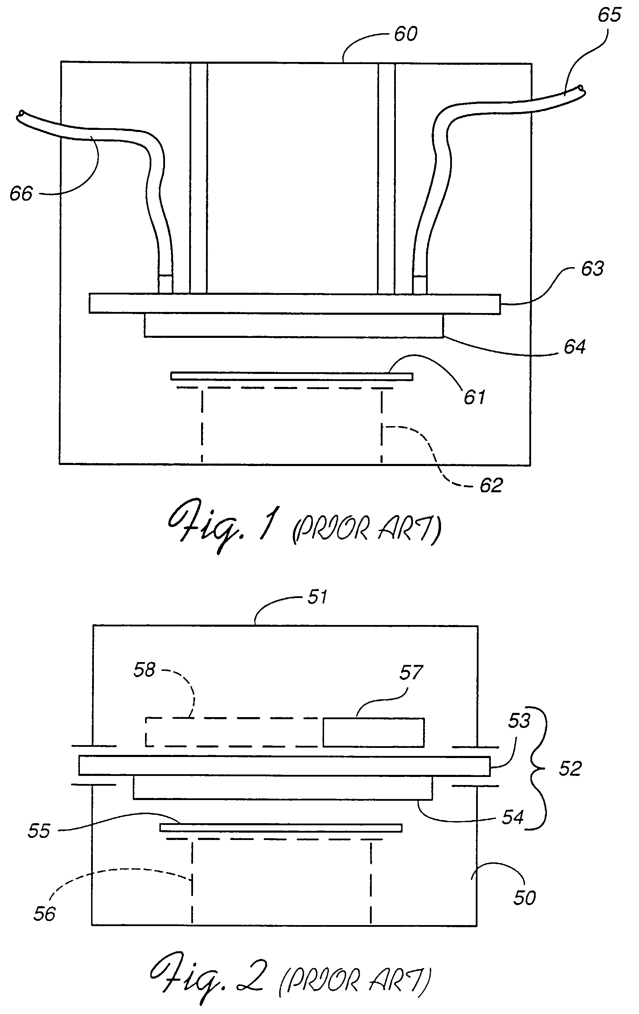

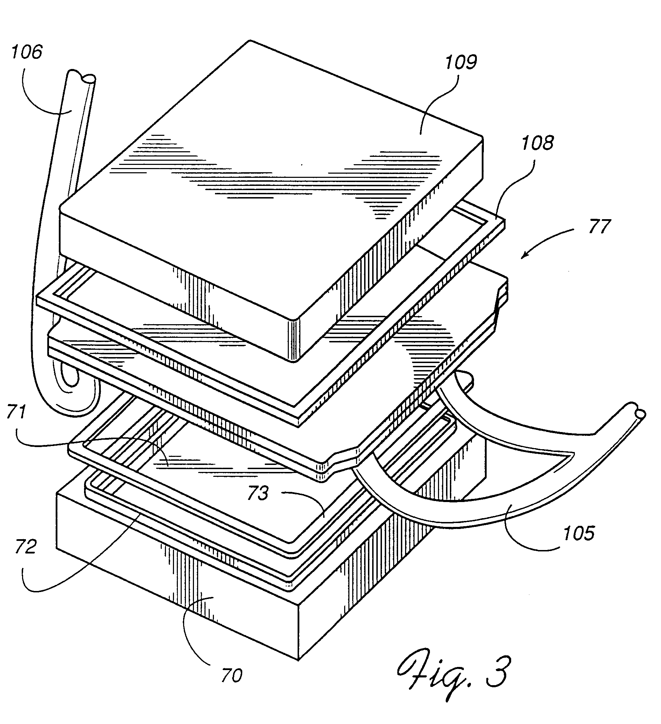

Considerable energy is used in generating the gas plasma and creating ion streams impacting on the cathode. This energy must be dissipated to avoid melting or nearly melting the structures and components involved. Common techniques used for cooling sputtering targets are shown in Figures 1 and 2. One technique, as used in many prior art sputtering devices, passes water or other cooling liquid through a fixed internal passage of the sputtering target. As shown in Figure 1, a first cooling liquid passageway such as a hose 65 supplies water or other cooling liquid to a target backing plate 63 where it passes through cavities or passages of the backing plate and out a second hose 66. The target 64 is thereby quickly cooled. To complete the picture of Figure 1, the sputtering chamber 60 includes an object (substrate) support structure 62 on which rests the substrate to be deposited 61. In this configuration the sputtering target is completely immersed in the process environment. A water-to-vacuum seal is often needed to prevent the water or other cooling liquid from leaking out of its passages. A magnetron sputtering cathode as described by Carlos dos Santos Pereiro Ribeiro in his U.S. Patent 4,826,584 is typical of the prior art showing cooling line attachments hidden behind the sputtering target and attached to the back of the target to pass liquid through structures adjacent to the target. While a magnet is not shown in Figure 2, commonly these devices have stationary or rotating magnets to assist in acting the ion flow and controlling the primary sputtering location.

Another technique for cooling a target is shown in Figure 2. A processing chamber 50 supports a sputtering table 56 supporting a substrate 55 to be sputter coated in close proximity to a target 54. The sputtering chamber 50 includes a circumferential top flange on which a target assembly 52 rests. The target assembly 52, consisting of a target backing plate 53 and the target 54, completely covers the flange of the processing chamber 50. A seal is made between the processing chamber 50 and ambient air outside the flange. A cooling chamber 51 encloses the top of the target assembly 52. A stationary magnet or a moveable magnet 57 is located closely adjacent to the back of the target backing plate 53. A magnet sweep mechanism (not shown) causes the movable magnet 57 to move in a magnet sweep zone as shown by the dashed lines 58. The moveable magnet 57 and portions of the magnet sweep mechanism (not shown), in this configuration, are immersed in cooling liquid which is circulated through the chamber behind the target to ensure cooling of the target.

In these configurations the target backing plate 63 is subjected to a strong vacuum pressure on the processing side (less than 1 torr) with a positive pressure of as much as several atmospheres on the cooling side. The actual pressure on the cooling side depends on the weight of the coolant in the cooling chamber and on the static and dynamic pressures of the coolant in the cooling chamber as enough coolant to maintain acceptable temperatures on the sputtering target is moved through the system. To avoid short-circuiting the flow of coolant through the chamber (from the inlet immediately by the shortest path to the discharge), distribution manifolds or flow directing restrictions are often placed in the path of the coolant to minimize short-circuiting and maximize cooling.

To obtain maximum thermal conduction between the cooling liquid and the target backing plate, it is necessary that the flow regimes in the cooling chamber 51 be such that any fluid boundary layer formed at and near the back of the target backing plate 53 be minimized or eliminated. Laminar cooling flow is not sufficient, the flow must be in the turbulent range to maximize heat transfer between the fluid target and the fluid. Higher fluid pressures are needed to generate the fluid velocities required for turbulent flow resulting in higher pressures in the cooling chamber 51.

For small sputtering targets, the target backing plate and target can easily be built to resist deflections due to the differential pressures between the vacuum in the processing chamber 50 and the ambient air pressure plus fluid pressure in the cooling chamber 51. However, when the size of the target and target backing plate is large, such as a flat glass panel to be used in a flat panel display of a computer or television screen, the thickness of the target and target backing plate must be substantially increased to avoid unacceptable deflections.

When a magnetron is used, the closer the magnets of the magnetron are to the surface of the sputtering target, the more effective the sputtering. Increasing the distance between the surface of the sputtering target and the magnets used for magnetron sputtering behind the target by increasing target thickness, substantially decreases the effect of the magnets on sputtering. Or conversely, much more powerful magnets need to be used in order to be sure that the magnet field is equally effective through the thickness of the thicker target and target backing plate combination.

The deflection of the target and target backing plate under the differential pressure between the processing chamber and the cooling chamber causes the target and target backing plate to bow substantially. Many targets are attached to their target backing plates using a relatively ineffective soldering or brazing technique. The bowing of the target backing plate and target creates an enormous stress in the solder or brazing material, or in the target material if it is softer, such that the probability of de-lamination or separation of the target from the target backing plate is greatly increased.

Methods that have been used in the past to attempt to overcome these difficulties include high pressure - high temperature diffusion bonding, explosion bonding, friction welding, or roll bonding of the target to its backing plate. In these processes there is a large non-uniform thermal or mechanical gradient to which the target and target backing plate are subjected. The microstructure of the various pieces is affected by the stress induced by thermal gradients or mechanical deflections and the dimensions of the pieces change. Subsequent processing (machining and or thermal stress reduction techniques) must often be used to arrive at a target-target backing plate assembly that is dimensionally stable without warpage under the thermal cycling of sputtering.

The disadvantages of the existing sputtering target systems as described above continue to inhibit the wide use of sputtering as an efficient and cost-effective means for applying surface coatings.

### SUMMARY OF THE INVENTION

The invention is defined in claims 1 and 9, respectively. Particular embodiments of the invention are set out in the dependent claims 2 to 8 and 10 to 17.

This invention relates to an improved configuration for a sputtering target and sputtering target backing plate. This configuration overcomes many of the drawbacks of the previous configurations and provides a structure and method to improve sputtering coverage and sputter large areas such as glass plates, and large semiconductive substrate (wafers), i.e., 200 or 300 mm diameter. In particular, large targets are required when stationary, full coverage deposition is required with high film quality for large substrates.

The new configuration includes a processing chamber having a top circumferential flange surface. A sputtering target assembly is supported on the flange. The target assembly includes a target separate from or integral with a target backing plate sealed to a cooling cover plate.

In instances the target material is separate from the target backing plate it is secured to the target backing plate using one of several commonly known joining techniques such as soldering, welding, or brazing. Additional techniques for joining the target to the target backing plate include bonding the target to its backing plate by use of diffusion bonding, by filler-metal, solid state, or liquid phase diffusion bonds - all at comparatively low temperatures and pressures. The bond between the initially separate target and target backing plate is always a concern because of the locally high temperatures of the process.

In a monolithic (integral) configuration the target (e.g. aluminum and its alloys) and target backing plate can be a single piece of material into which O-ring grooves and other fixtures are machined to seal with the process chamber.

The cooling cover plate is firmly attached (bonded) or clamped to the back (top) of the target backing plate. The cooling cover plate has cavities or grooves therein which provide a flow path (passages) for cooling fluid. The cooling fluid cavities or grooves are configured in such a way as to distribute the cooling liquid flow over a substantial area of the target backing plate so as to provide a maximum cooling or heating effect over the whole plate. The flow may be straight through, or in a serpentine or looping path.

The cooling cover plate must be tightly joined with the back of the target backing plate so that a fluid tight seal is created for the cooling fluid. The facing sides of the target backing plate may be planar and may be sealed by a gasketed connection including at least one or more gaskets compressed by one or more fasteners. The gasketed connection forms a generally fluid tight seal surrounding the heat exchange cooling passages, and forms a generally fluid tight seal surrounding each of the one or more fasteners securing a field of said cooling cover plate within the inside perimeter of a portion of the gasketed connection providing the generally fluid tight seal between said target backing plate and the cooling cover plate surrounding said heat exchange cooling passages. The gasket may be a one piece die out gasket which covers all sealing surfaces at once so that when fasteners clamp the gasket in place a fluid tight seal is created, to contain the cooling medium in the cooling passages of the target assembly.

A portion of the internal surfaces of the cooling passages can be grit blasted to increase the roughness of the surface finish to improve the efficiency of heat transfer as cooling liquid flows through the cooling passages.

Cooling passage grooves are machined or cast (or otherwise formed) into the side of the cooling cover plate facing the target backing plate. The grooves have fins or walls between them. Fastener holes pass through the fins and out the ends of some of the fins at periodic locations along the fin from end to end. Fasteners pass through the fastener passages and a portion of a gasket surrounding the fastener passage at the end of the fin. When the fastener is tightened the gasket is clamped between the target backing plate and the end of the fin of the cooling cover plate to seal the path between the cooling passages and the fastener opening. The fasteners clamping the cooling cover plate to the between the contact and are secured to the backing plate, they help maintain the dimensions of the cooling passages over the wide span of the cooling cover plate. In this way cooling fluid pressure in the cooling passages does not cause bowing of the cooling cover plate or the target and its target backing plate.

The cooling cover plate can be joined to the target backing plate by any reliable means, however, it is important that the coefficient of thermal expansion of the target backing plate and its cover be closely matched. If not closely matched, then the shear stress associated with differential thermal expansion between the pieces causes bond and seal failure. The differential strain between the target backing plate and a cooling cover plate of different materials can be minimized by using pins at intermediate locations across the field between the edges of the plates. Screws or bolts at intermediate locations can also help establish and assure that de-bonding (evidenced by fluid leakage) does not take place.

In an alternate configuration, cooling water passages and grooves can also be provided in the target backing plate. The cooling cover plate is then a flat plate to be bonded over the cooling passages in the target backing plate.

For reusable target assemblies, the target backing cover plate can seal the cooling channel using a precisely cut sheet of high temperature elastomeric material sandwiched between the backing plate and cover plate and squeezed with removable fasteners spaced regularly across the target backing plate area to bond the cover to the target backing plate to act as a gasket to seal the cooling fluid passages. The removable fastener receiving holes are provided with gas exhaust openings (fluid passages) which release gas from the fastener hole space which might otherwise leak gas slowly for a prolonged time and prevent a rapid pump down of the vacuum equalizing chamber and therefore delay the beginning of processing.

The target, target backing plate, and cooling cover plate make up a target assembly which is placed over the sputtering chamber. When the target assembly is made in a configuration with a rigid cross section or reinforced to minimize bending, sputtering can take place while the target carries the load of the differential pressure between ambient conditions and the vacuum of the processing chamber.

Alternatively, a top chamber can be put in position to enclose a magnet and be sealed to the top of the target assembly. When sputtering is desired, the pressures in both the sputtering chamber and the top chamber are reduced substantially and nearly equally. The target assembly then acts as a diaphragm separating the two chambers of nearly equal pressure. The cooling fluid flowing through the cooling passages in the target assembly is isolated from both of the vacuum chambers. The deflection of the target assembly and target due to cooling fluid pressures is reduced, if not completely eliminated. By the fastener connection between the target backing plate and the ends of the fins of the cooling cover plate.

A magnet sweeping mechanism placed in the dry top chamber does not need to overcome the resistance of fluid as it would if it were immersed in fluid. Further, since the target assembly is acting as a diaphragm sealing two chambers of nearly identical pressure, the target assembly can be made very thin to decrease the distance of the magnets from the target face.

Many types of high-intensity magnets reduce their magnetic field strength at elevated temperatures. When using a configuration according to this invention, unlike previous configurations where the magnets are immersed in the hot cooling fluid, the magnets' temperature increases very little, if at all, due to the sputtering process. The magnets are located in the top evacuated chamber and there is virtually no conductive heat flow to the magnets and radiative heat flow from the target assembly to the magnets will be quite minuscule as the cooling cover plate face of the target assembly will have a maximum temperature substantially identical with that of the average cooling fluid temperature, e.g. 50°C. At such temperatures, radiative heat transfer is negligible.

The electrically charged target assembly should be isolated from the sputtering process chamber and the top chamber as well as from operator contact. Insulating rings placed above, below, and outside of the target assembly provide such isolation. Electrical power is provided to the target plate through a power connection opening.

Conduction of electrical current through the cooling media becomes negligible when a high purity water or other cooling fluid is used in the cooling passages. A non-conducting hose matrial is used to connect the target assembly to outside cooling/heating fluid source(s).

The cooling fluid inlet and outlet flows can be routed through a plastic (acrylic, polycarbonate, etc.) manifold, or hose fittings with quick disconnect type fittings which may be attached directly to the target backing plate. The plastic manifold is bolted to the target backing plate and acts as an insulating barrier together with other insulating pieces to prevent an operator from contacting the highly energized target plate or its electrical connections.

In configurations according to the invention, very large substrates to be coated can be deposited from targets having sizes substantially equal to the size of the substrates. For instance, large glass panel displays as might be used for large television-like screens whose dimensions are as much as two or three feet in any direction could be deposited from the sputtering target and sputtering chambers as described herein, similarly large circular water semiconductors 200-300 mm in diameter can be evenly sputter coated.

Further, when movable magnets are swept behind a conventional target assembly, the target is irregularly eroded which causes the distance between the target and the substrate being sputter coated to change, thereby affecting the quality, i.e., uniformity, of the coating that is sputter deposited on the substrate being sputtered. The invention can partially compensate for this dimensional change due to irregular erosion, the pressures in the two chambers may be adjusted to control the bow in the target assembly, thereby mechanically adjusting the distance between the bowed (displaced) areas on the target surface and the substrate to be sputtered so that a high degree of uniformity of deposition is maintained even when the sputtering target is nearing the end of its useful life. Also, since the pressures in the two chambers can be adjusted to control the bow of the target assembly, the same target thickness and magnet field strength can be employed in sputtering systems with small dimensions as well as those having substantially larger dimensions to sputter, such as glass panels.

Cooling water supplies are connected to the target assembly outside the vacuum so that all vacuum-to-water seals in these connections have been eliminated. Leakage across vacuum to water seals (e.g., through the fastener holes) is limited to leakage into the equalizing chamber, which can immediately be detected by monitoring the level of vacuum there. In a configuration according to the invention failure of any seals will not have a catastrophic effect on the process or the target.

### BRIEF DESCRIPTION OF THE DRAWINGS

Figure 1 is a cross sectional view of a prior art sputtering chamber wherein the target and target assembly are immersed within the processing chamber and cooling fluid is provided to the target through seals in the wall of the processing chamber;
Figure 2 is a cross sectional view of a prior art sputtering chamber separated from a cooling chamber by a target assembly;
Figure 3 is an exploded view of an embodiment according to the invention;
Figure 4 is an exploded perspective view of the members of a target assembly according to the invention, wherein the target is at the bottom facing down;
Figure 5 is an exploded perspective view of the members of a target assembly according to the invention, wherein the target is at the top facing up;
Figure 6 is bottom view of a target assembly configured with screw holes around the cooling passage inlet and outlet openings according to the invention;
Figure 7 is a cross sectional view of Figure 6 taken at 7-7;
Figure 8 is a cross sectional view of Figure 6 taken at 8-8;
Figure 9 shows a detailed cross sectional view of target assembly according to the invention where the target material is separate from the target backing plate;
Figure 10 shows a detailed cross sectional view of target assembly according to the invention where the target material is one piece with the target backing plate;
Figure 11 shows a detailed cross sectional view of a screw hole connection of a finned target backing plate according to the invention;
Figure 12 shows a detailed cross sectional view of dimensional details of a finned target backing plate according to the invention;
Figure 13 shows a detailed cross sectional view of a screw connection between a finned cooling cover plate and a target backing plate according to the invention;
Figure 14 is an alternate configuration according to the invention where the target backing plate is finned and the cooling cover plate is a generally flat plate, showing a detailed cross sectional view of target assembly where the target material is separate from the target backing plate;
Figure 15 shows a plan view of a cooling cover plate according to the invention showing the configuration of finned passages therein;
Figure 15A shows a side cross sectional view of a cooling cover plate of Fig. 15 taken at 15A-15A;
Figure 16 shows the lengthwise dimensional relationship of the fins shown in Fig. 15;
Figure 17 shows the area of both the target backing plate and cooling cover plate (fins omitted for clarity) showing the areas of the cooling passages designated for surface treatment;
Figure 18 shows a plan view of the back side of a cooling cover plate according to the invention;
Figure 19 is a plan view of a die cut gasket showing the configuration for sealing between the target, backing plate and the cooling cover plate;
Figure 20 is a plan view the target side of an alternate embodiment of a target assembly according to the invention;
Figures 21 is a plan view of fluid passages and fins for a cooling cover plate, of the embodiment of Figure 20;
Figures 22 and 23 are assembled side and exploded side views of the configuration of a cooling cover plate as shown in Fig. 21 and target assembly as shown in Figure 20;
Figure 24 is an exploded view of a sputtering target assembly in context with a vacuum processing chamber according to the invention;
Figure 25 is a cross sectional view of a sputtering device of Fig. 24 taken at 25-25 showing a target assembly having a cooling cover plate with grooves therein according to the invention;
Figure 26 shows a cross section of the sputtering chamber of Figure 24 taken at 26-26; and
Figure 27 is a cross sectional detail view of the rough vacuum passage connection to the intermediate seal space around the processing chamber according to the invention for the configuration of Figure 24 taken at 27-27.

### DETAILED DESCRIPTION OF THE PREFERRED EMBODIMENTS

### General Structure

An embodiment according to this invention provides a cooling passage sealed within a sputtering target assembly. The target assembly is sealed to a vacuum processing chamber. Cooling fluid flowing through the cooling passages provides cooling to a sputtering target assembly in an efficient manner and avoids water-to-vacuum sealing problems. The target assembly is sealed between two vacuum chambers so as to obtain a predetermined low stress deformation in the target assembly.

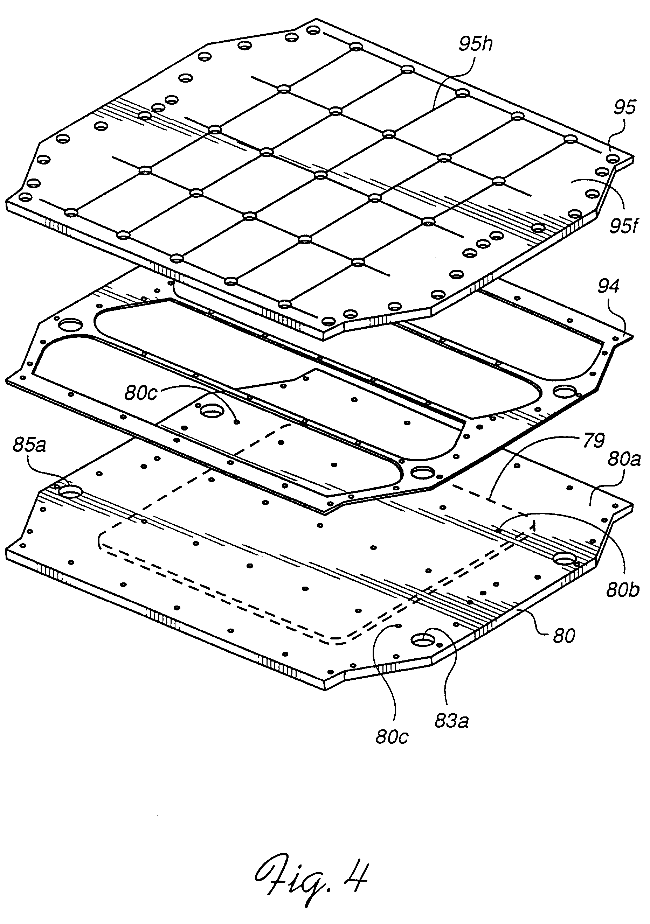

A general configuration of an embodiment according to the invention is shown in Figure 3. A processing/ sputtering chamber 70 encloses a substrate 71 to be sputter coated .The substrate 71 is surrounded by a dark space ring 72 to prevent deposition of material from beyond the edge of the sputtering target. A lower insulating ring 73 (preferably alumina) rests on the top flange of the processing/sputtering chamber 70. A laminated target assembly 77 is supported on and sealed to the lower insulating ring 73. Inlet and outlet cooling lines 105, 106 provide cooling liquid to the target assembly 77. An upper insulating ring 108 insulates and seals a top chamber 109 from the target assembly 77.

This general configuration as shown in Figure 3 provides the basis for specific embodiments of the invention as described below.

### Gasketed Target Assembly

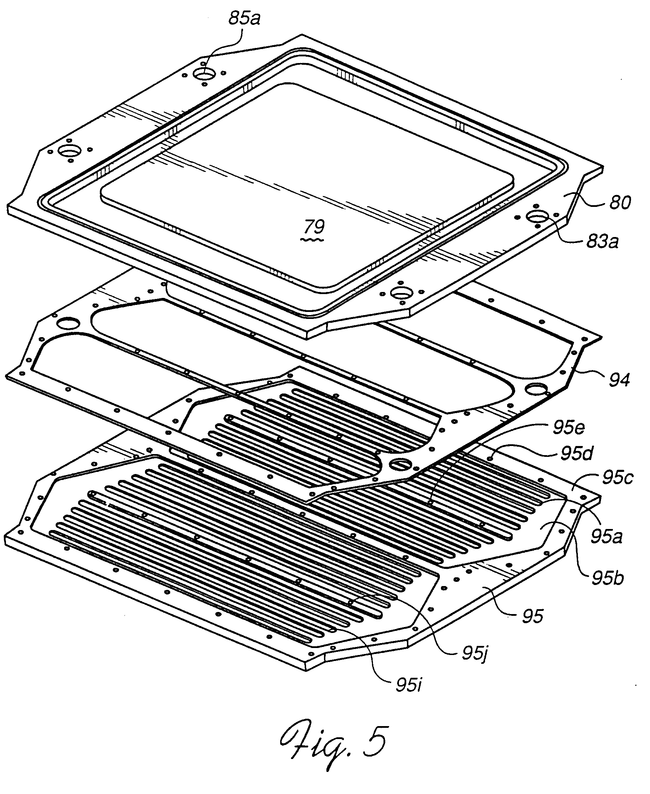

Figures 4 and 5 present exploded perspective views of the a target assembly according to the invention. Each includes a target 79 fixed to a target backing plate 80 whose back surface 80a is generally flat having threaded screw holes 80b therein. The backing plate also includes cooling liquid inlet 83a and outlet 85a openings therein The backing plate 80 is shaped so that the inlet 83a and outlet 85a openings are positioned outside the seal sealing the target assembly to the vacuum chamber so that cooling fluid hoses 105, 106 or the like can be connected as pictured in Fig. 3.

A die cut gasket 94 is positioned between the target backing plate 80 and the cooling cover plate 95.

The cooling cover plate 95 on its inside surface (Fig. 5) includes a series of fins 95a rising from a surface 95b recessed below the edge flange 95c of the cooling cover plate 95. The details of the configuration of the fins 95a is discussed below. The cooling cover plate 95 includes a series of central and perimeter attachment holes 95d, 95e whose location correlates to the threaded holes 80b on the back surface 80a of the target backing plate 80 (Fig. 4). The central and perimeter holes 95d, 95e have a beveled countersink 95g as detailed in Figure 11. The countersink opening has an angle of approximately 82 degrees and has an opening diameter 95n of 0.66" (16.8 mm) at the surface and is cut to a depth 95p of 0.194" (4.9 mm). The through holes 95e in the cooling backing plate have diameter 95q of 0.322" (8.2. mm).

The outside surface 95f of the cooling cover plate 95 (Fig. 4) in the area which will be located within the area under the vacuum equalizing chamber 109 (Fig. 3) includes a series of screw hole gas vent grooves 95h. These grooves 95h form a grid pattern on the outer surface of the cooling cover plate 95 as seen in Figure 4. Gas outlets around each hole are required, the grid pattern in embodiment is provided as a machining and cleaning convenience.

It is important that the clamping of the screw head to the countersink portion of the screw hole not seal any gasses in the thread space which could later leak out. The grooves 95h provide vent opening between the countersink surface of the cooling cover plate and the corresponding beveled surface of its mating screw head through which gasses can freely pass. If the beveled countersink surfaces of the hole and mating screw head were tightly sealed to one another then when vacuum pump down occurs in the equalizing top chamber (i.e., 109 in Fig 3), gas molecules located in the thread space and the bottom end of the screw would ostensibly be trapped there. However perfect metal to metal sealing is unlikely. Therefore when the equalizing chamber was pumped down, the gas inside an imperfectly sealed countersink screw hole would tend to leak slowly into the equalizing chamber. This slow leakage from all the exposed screw holes would continue to slowly add gas molecules to the equalizing chamber until the high concentration of molecules in the screw hole has been rarefied to equalize with the pressure in the equalizing chamber. Without the vent holes/grooves, the slow release of gas molecules from the thread space prevents the pressure in the equalizing chamber from dropping to the low vacuum values < 10⁻³ torr desired for processing without experiencing a prolonged pump down time.

The groove 95h in this configuration is a half-round groove with a 0.063" (1.6 mm) radius and a 0.063" (1.6 mm) depth.

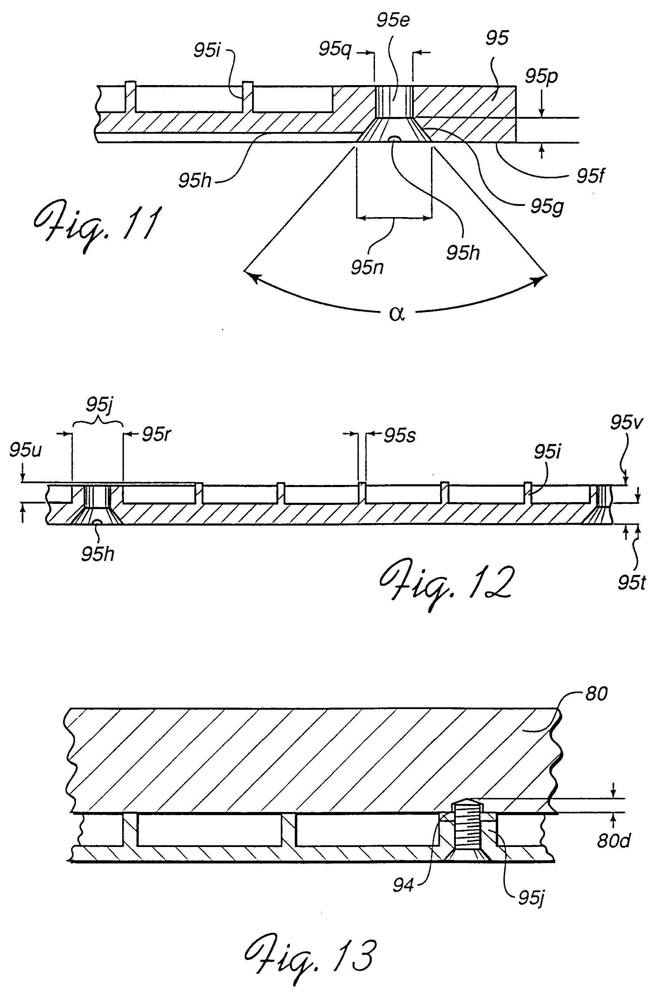

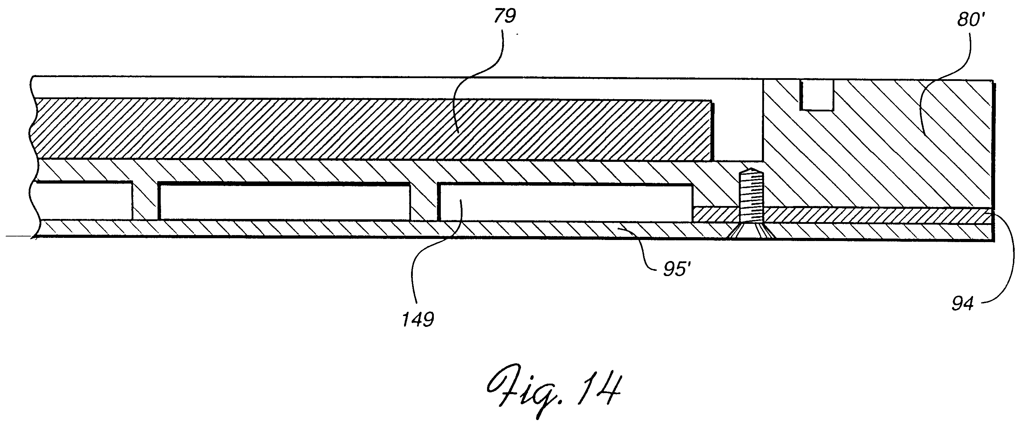

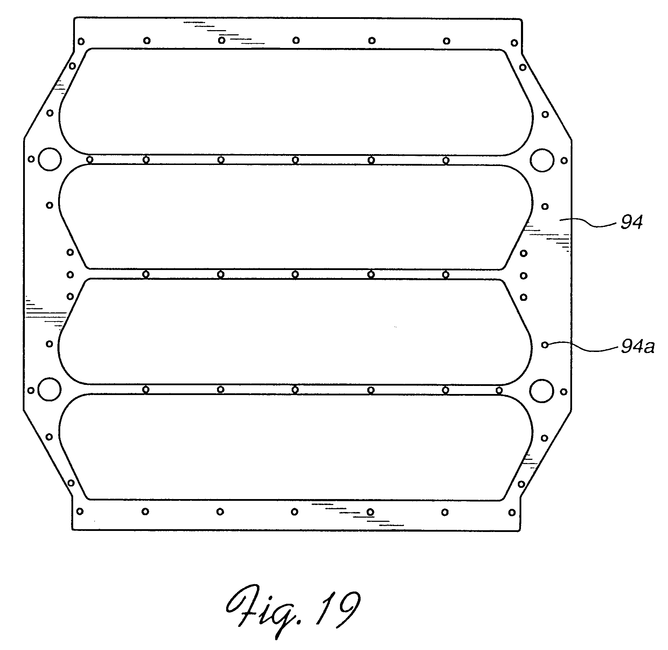

On the other (front) side of the cooling cover plate 95 (Fig. 12), the ends of the intermediate cooling fins 95i between the perimeter flanges extend a predetermined distance beyond the imaginary plane coinciding with the surfaces of the faces of the perimeter flange 95c and the intermediate support pier fins 95j (Figs. 9-13). The elastomer gasket 94 in its relaxed state has a relaxed thickness approximately 146% thicker than the distance the ends of the intermediate cooling fins 95i extend beyond the imaginary plane so when the target backing plate 80 and the cooling cover plate 95 are clamped together with the gasket 94 in between, the clamping strain is stopped by the ends of the intermediate fins 95i contacting the flat back surface of the target backing plate 80. The gasket 94 has then been clamped from its relaxed 100% to approximately 68% of the relaxedt thickness to thereby seal all the screw openings and the perimeter flange without leakage. The width 93r of the intermediate support pier fins 95j having a 100% (12.7 width) has a hole through the gasket at this and all screw locations of 63% of the 94a (Fig. 19) of the full wide. The pieces are clamped together preferably by using stainless steel screws preferably torqued to 25 ft-lbs (16.8 kg-m) threaded into 0.312" dia. - 24 thread per inch (1.058 mm thread) holes in the back of the backing plate which preferably have a maximum depth of 0.250" (6.35 mm). Two alignment dowel holes 80c (Fig. 4) fitted with dowels (not shown) assist in aligning the two plates and the gasket to one another before screws are inserted and tightened to clamp the pieces together.

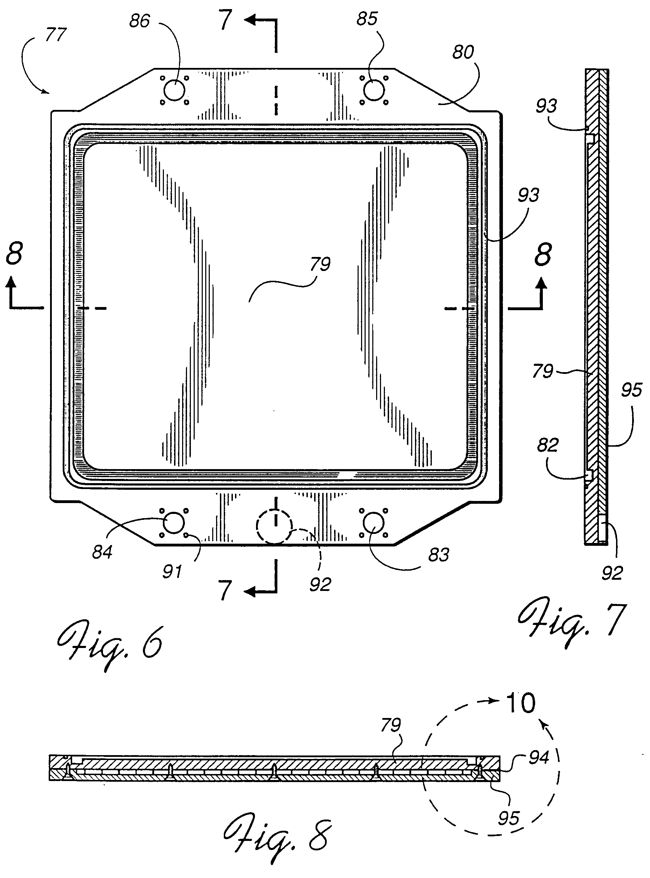

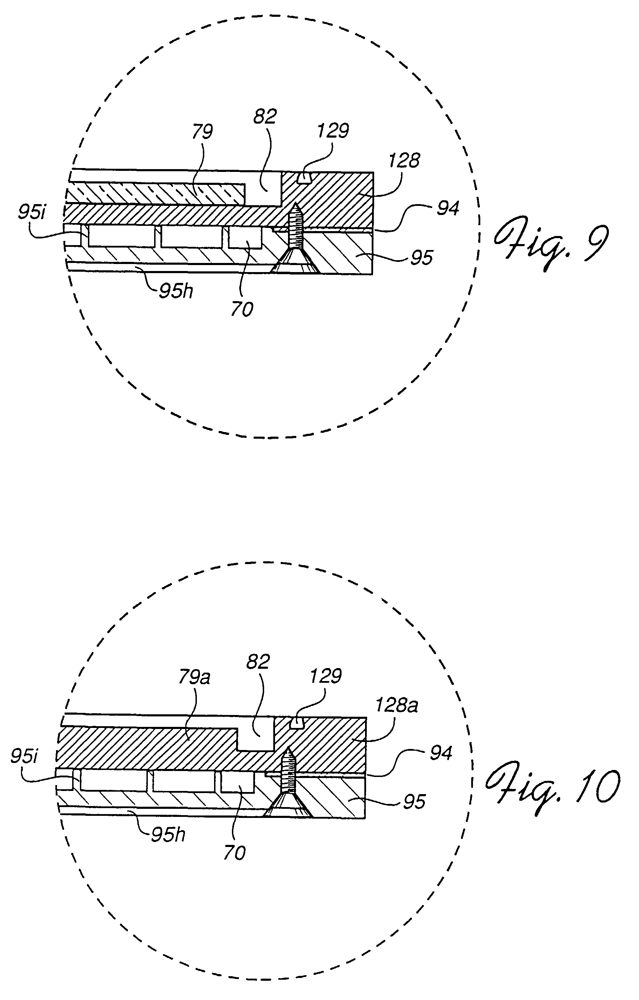

Figure 6 shows a bottom view of the target assembly 77. Figures 7 and 8 are perpendicularly opposed cross sectional side views. The target 79 comprising the material to be sputtered is centrally located in the target backing plate 80. The target 79 and target backing plate 80 may be constructed of a single monolithic material, such as aluminum or titanium or the target material may be different from the target backing material, in which case the target material 79 must be securely attached to the target backing plate 80.

Figure 9 shows a cross sectional closeup side view of an edge of a target 79 separate from a target backing plate 128, but bonded to it.

Figure 10 shows a cross sectional closeup side view of an edge of a target 79 formed as a monolith with a target backing plate 128a.

A dark space ring groove 82 surrounds the target 79. When the target 79 and target backing plate 128a are a monolith (Fig. 10), this groove 82 is machined (or cast) into the plate. When, as in Figure 9, the target 79 and target backing plate 128 are of different materials, the lateral distance between the edges of the two pieces 79 and 128 provides this groove 82. An O-ring sealing groove 93 (129 in Figures 9 - 10) surrounds the outside of the dark space ring groove 82 and is sized to contain an O-ring (not shown) to seal the target backing plate to the sputtering/processing chamber 70.

A cooling cover plate 95 acts as the back of a sandwich comprised of the target backing plate 80, an elastomeric gasket (preferably silicon rubber Durometer 70 Shore A - approximately 0.070" (1.78 mm) thick) and the back side of the target backing plate 80. The cooling cover plate 95 has a series of cooling passage grooves 70 machined, cast or formed by other means into its inside face. A power connection hole 92 (Figures 6 and 7) is located in the cooling cover plate 95 and through the gasket to be sure that when electrical power is applied to the target it reaches the target backing plate 95 without undue resistance. This power connection is not shown in other views, but is provided in a similar way on all target assemblies.

The cooling inlet and outlet features 83, 84, 85, 86 provide one configuration of flow through cooling.

Figure 11 shows the relationship of the cooling cover plate features around a perimeter screw hole 95e of the cooling cover plate, as described above. The intermediate fins 95i can be seen extending beyond the top surface of the cooling cover plate 95

Figure 12 shows details of the configuration of the cooling cover plate fins 95i. The intermediate fins 95i have a width 95s of 16% of the width 95r of the inner support pier 95j. The thickness 95t of the cover plate behind the cooling passages and of the fin height 95u are 52% and 57% of the full depth of the pier 95v (100%).

Figure 13 highlights the depth into the target backing plate 80 of the screw holes securing the pieces together. The screw hole depth 80d is approximately 0.25" (6.35 mm). Note that a portion of the clamped gasket 94 under the inner support pier 95j is shown.

Figure 14 shows a target 79 securely attached to the target backing plate 80' which has cooling grooves 149 formed therein. In this configuration the cooling cover plate 95' is a flat sheet clamped through the gasket 94 to the target backing plate 80'.

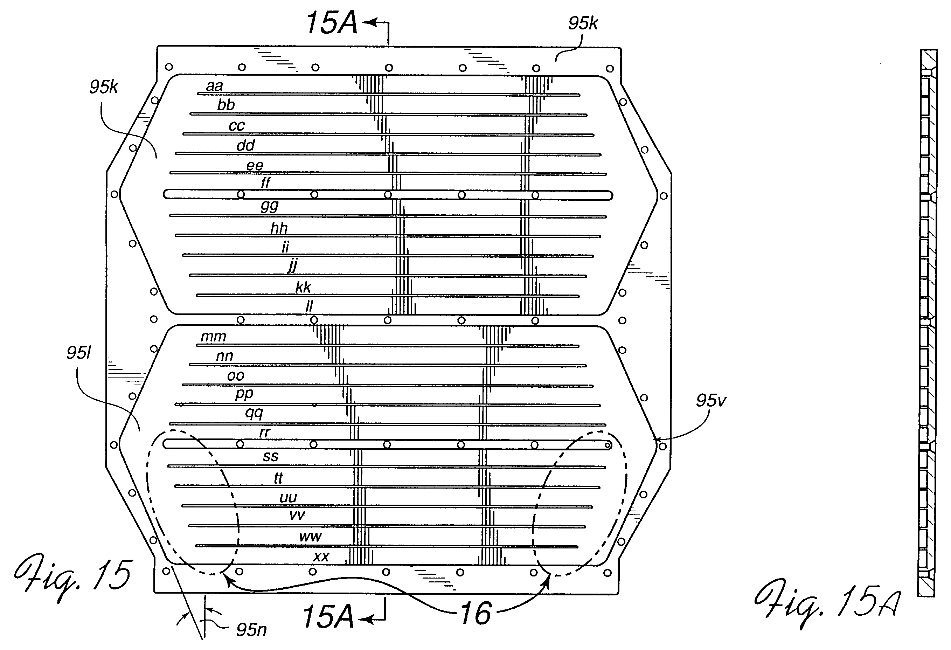

Figures 15 and 15A show top and side cross sectional views of the cooling cover plate 95 according to the invention. Two cooling passage chambers 95k, 95l include cooling fins which are configured to have a spacing between each of them as a perentage of the total spacing from top to bottom as shown in Figure 15 of: aa - 3.2%; bb - 4.4%; cc - 4.4%; dd - 4.4%; ee - 4.4%; ff - 4.3%; gg - 4.2%; hh - 4.4%; ii - 4.4%; jj - 4.4%; kk - 4.4%; ll - 3.2%; mm - 3.2%; nn - 4.4%; oo - 4.4%; pp - 4.4%; qq - 4.4%; rr - 4.2%; ss - 4.3%; tt - 4.4%; uu - 4.4%; vv - 4.4%; ww - 4.4%; and xx - 3.2% progressively.

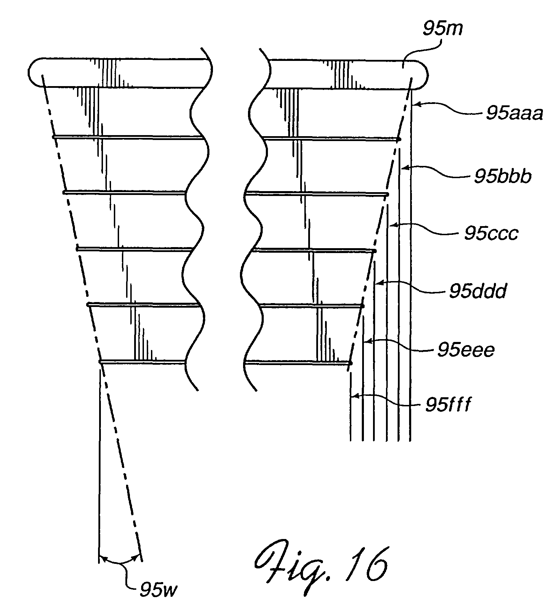

In Figure 16 the ends of the fins as shown in Figure 15 are aligned with one another and are symmetrical about a centerline (the central support pier in each cooling passage chambers 95k, 95l) and progressively get shorter along a line forming an approximately 12 degree angle 95w from the center of the radius of the support pier. The center to center distance 95aaa of the support pier fin 95m is about 22.55" (572.8 mm) and it has a 0.25" radius turned from these centers. The intermediate fin length varies from the longest to the shortest from the center of each cooling passage chambers as follows: 95aaa - 22.55 (572.8 mm); 95bbb - 22.12, (561.8 mm); 95ccc - 21.7, (551.2 mm); 95ddd - 21.26, (540.0 mm); 95eee - 20.84, (529.3 mm); and 95fff - 20.4, (518.2 mm); the cooling passage end angle 95n (Fig. 15) facing the line of fins is approximately 24.5 degrees from vertical as seen in Fig. 15. the extreme length of the cooling channel end to end 95x is approximately 27.9", (709.8 mm).

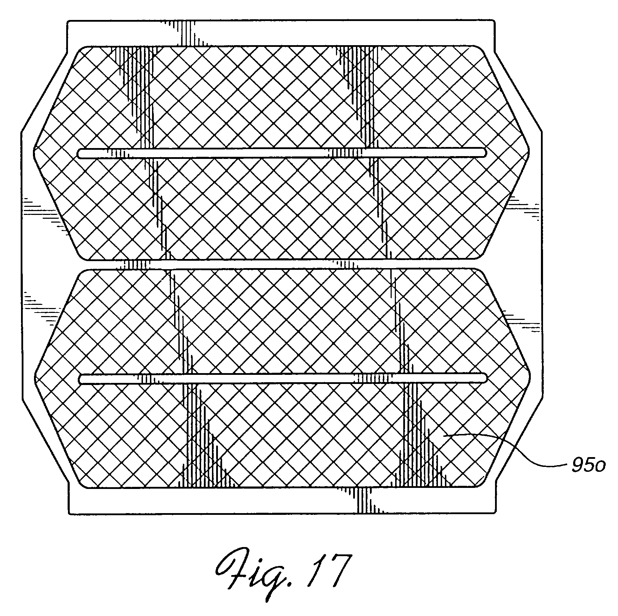

Figure 17 provides a plan view of approximately the surface area 95o which is to be roughened (for example by grit blasting #32) on both the back side of the target backing plate and on the fin side of the cooling cover plate. The edges of the intermediate support fin or their corresponding contact locations on the target backing plate are not treated and have a surface finish, like the rest of the items of 64 RMS. The fins of the cooling cover plate are not shown for clarity, and the target backing plate has no fins. Grit blasting provides a roughened surface which increases the surface area available for heat transfer and also increases the roughness of the surface which increases the likelihood that only flow in the turbulent region consistent with good heat transfer will be present in the cooling passages.

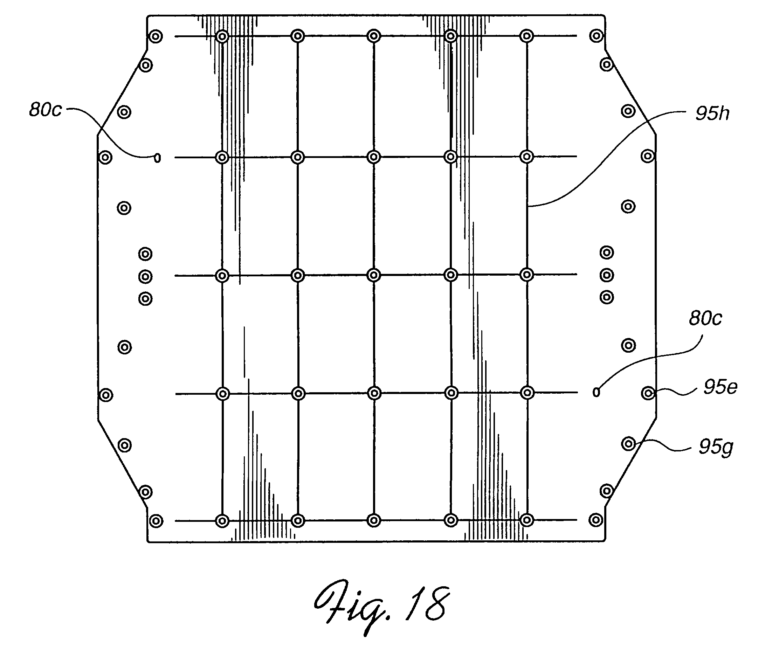

Figure 18 shows a plan view of the back of the cooling cover plate 95 as already discussed above for Figs. 4 and 5.

Figure 19 shows a plan view of the elastomer die cut gasket 94 as already discussed above for Figs. 4 and 5.

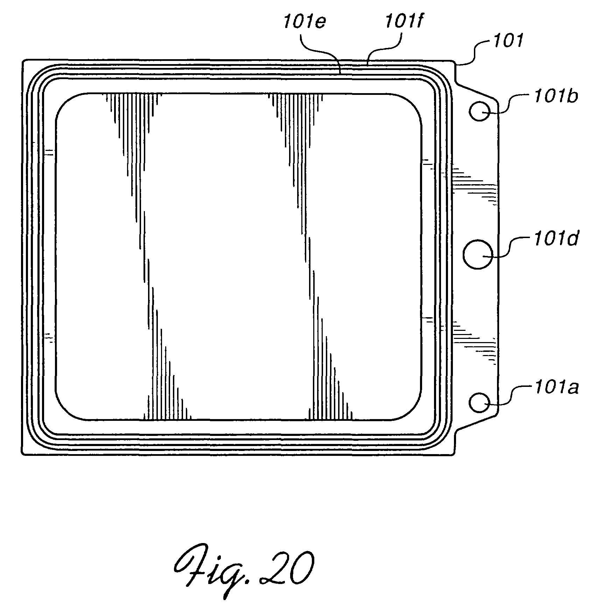

Fig. 20 shows a plan view of a target side of an alternate configuration of a target assembly 101 according to the invention. Two O-ring sealing grooves 101e, 101e which provide better sealing are pictured.

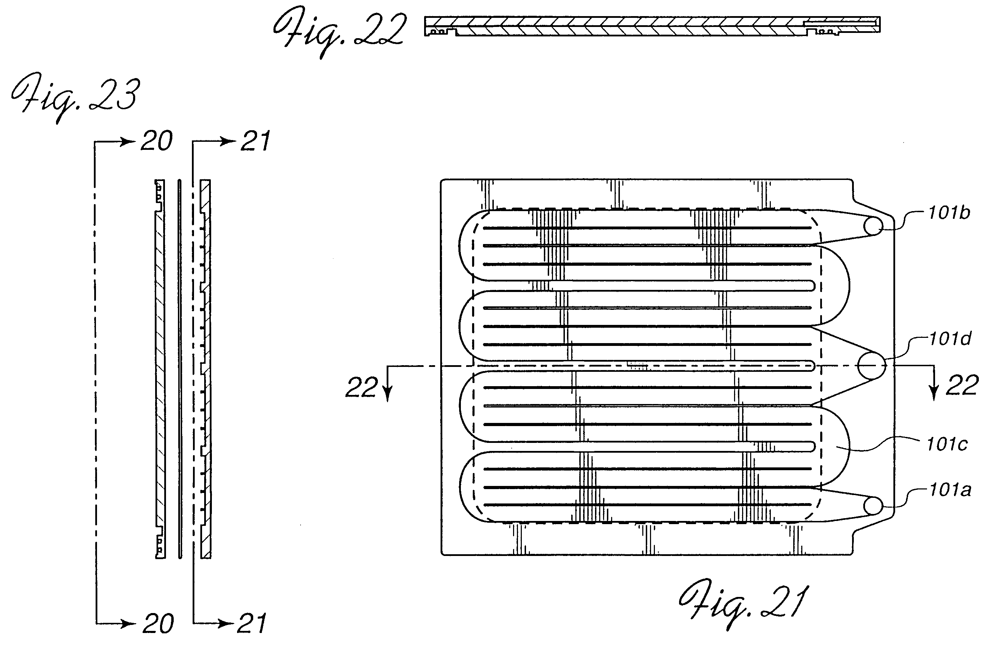

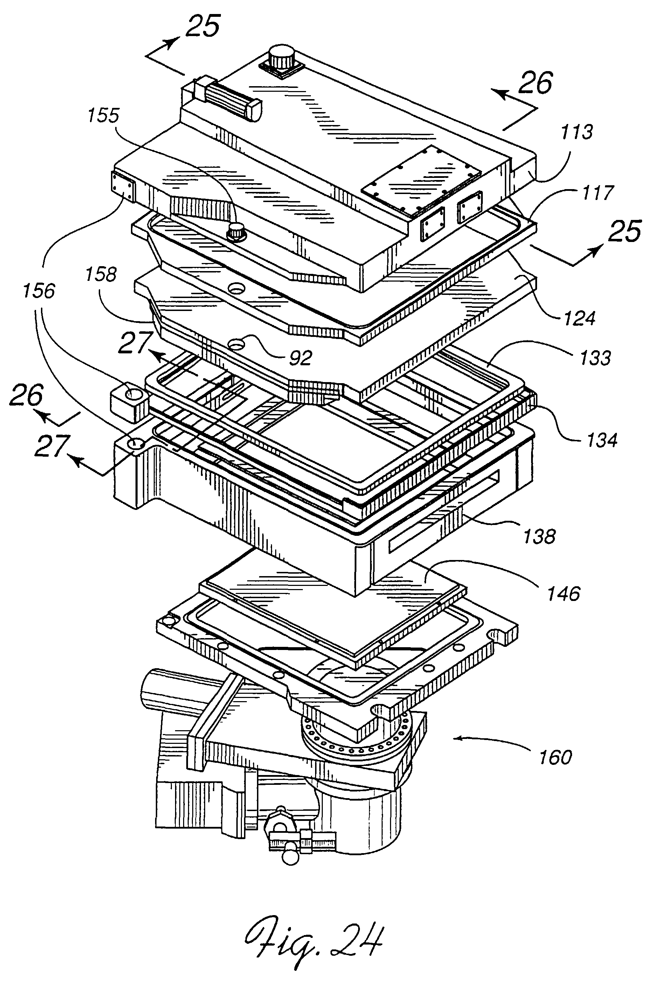

Figure 21, 22, and 23 show two cooling liquid inlet openings 101a, 101b which provide passage to finned cooling passages 101c which loop in a series of racetrack type lanes to a central outlet opening 101d. An exploded cross sectional side view of the embodiment is shown in Fig. 23. As in previous embodiments an elastomer gasket seals the perimeter spaces and the screw hole openings to create a fluid tight cooling passage through which the cooling liquid can flow.

In the configurations as shown, cooling flow rates of 3-7 gallons per minute at inlet coolant (e.g., water) temperatures of 122°F (50°C) at pressure of up to 60 psi at the inlet appear to give exceptional cooling performance.

### Mating of Target Assembly To Chamber

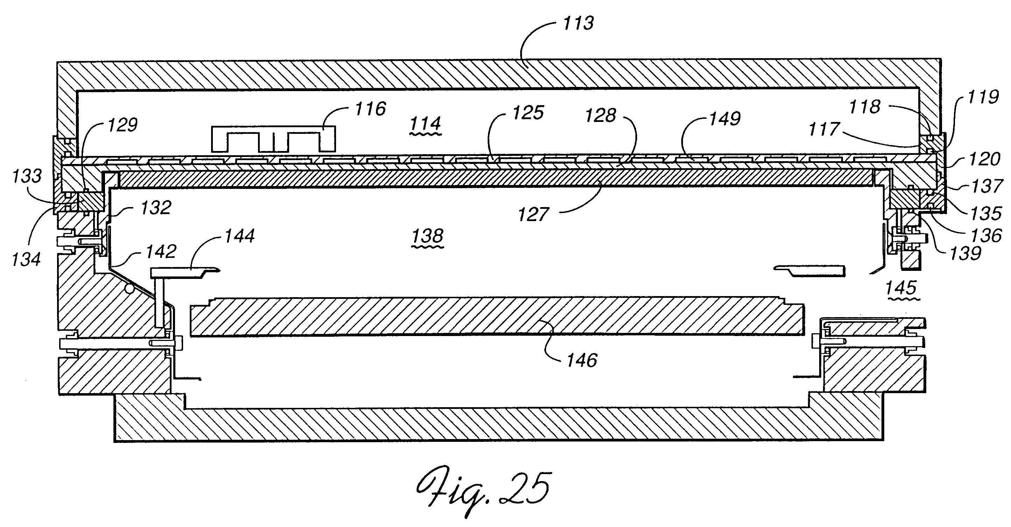

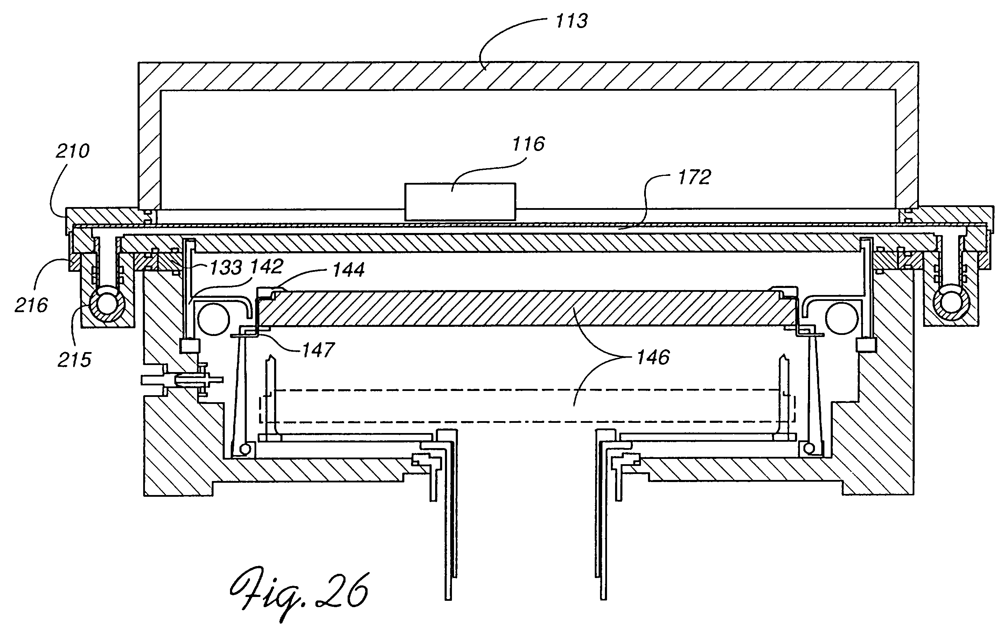

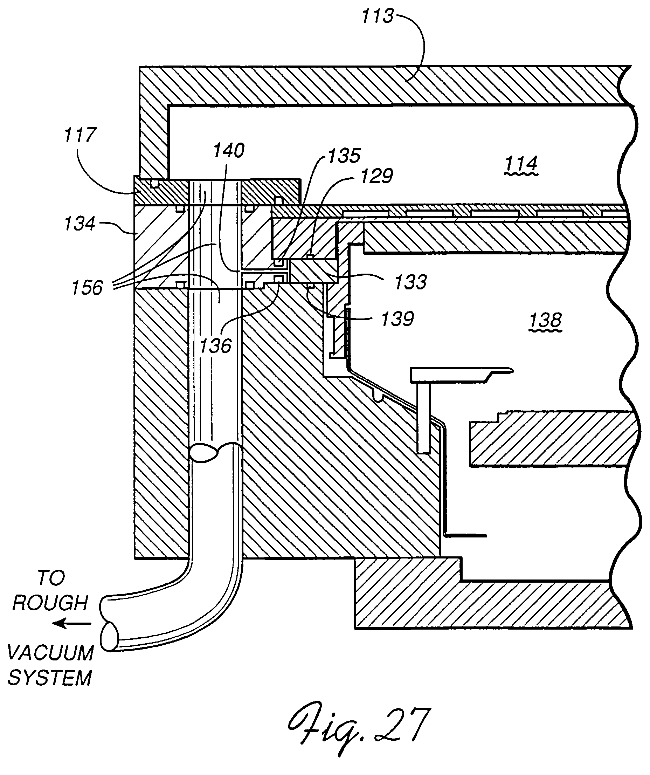

Figure 24 shows an exploded perspective view of the sputtering device pictured in Figures 25, 26, and 27.

Figure 24 shows an exploded view of the chamber configuration shown in Figures 25,26, and 27. The target assembly 124 is shown already attached to a cooling fluid manifold 158. In this configuration, this cooling fluid manifold usually made from a non-conducting plastic such as polycarbonate is attached by means of the cooling attachment screw holes to the target assembly 124. Piping having non-conducting properties, such as neoprene hoses, is attached to this polycarbonate manifold, to circulate a highly resistive, e.g. 200K ohm/in. minimum, cooling fluid. In this configuration a fluid path (hose length) of at least approximately 2 ft in length prevents large currents from leaking through the cooling fluid to connected machinery.

A clear understanding of the details of an embodiment according to the invention can be shown by reviewing the cross section of a sputtering device as shown in Figure 25. The sputtering/processing chamber 138 is accessed through a slit valve 145 such that a substrate to be deposited (not shown) is delivered to a sputtering pedestal 146. The sputtering pedestal 146, being movable, is then moved vertically into position by vertical adjustment means (not shown) opposite the sputter target 79. A shadow frame 144 covers the outside edge of the substrate to prevent deposition on its edge. The sputtering/processing chamber 138 is lined with an over-spray shield or chamber liner 142. This liner 142 is more easily removed and cleaned than the chamber internal surfaces. The sputtering/processing chamber 138 has a top flange O-ring groove 139 to contain a sealing O-ring (not shown). An insulating ring, e.g. a ceramic (alumina) ring 133 (similar to item 73 shown in Figure 3) rests on the top flange of the processing chamber 138. An outer insulator 134 surrounds the ceramic insulator 133 and has a lower O-ring groove 136, an upper O-ring groove 135, and an upward projecting insulating skirt 137. O-rings preferably made of Viton (not shown) are disposed in these grooves. The outer insulator 134 slightly overlaps the outside corner of the processing chamber upper flange. This slight overlap precisely locates the outer insulator 134 as well as the ceramic insulator 133 on the upper flange of the processing chamber 138. A dark space shield 132 is located inside the ceramic insulator 133 and projects upwardly towards the target backing plate 80.

The target assembly 124 in this embodiment according to the invention includes a target 79, a target backing plate 80 and a backing plate cooling cover 95 having cooling grooves 149 therein. This target assembly 124 has a target backing plate O-ring groove 129 to seal against ceramic insulator 133 using an O-ring (e.g. Viton) (not shown). The upward projecting skirt 137 of the outer insulator 134 along with the upward projecting dark space shield 132 locates the target assembly on the processing chamber 138.

Once the target assembly 124 is in position, an upper insulator 117 having a lower O-ring groove 119 and an upper O-ring groove 118 both having O-rings (not shown) rests on the top of the target assembly, specifically on the back of the backing plate cooling cover 95. The back of the cover plate 95 may be covered by a thin sheet of insulating material such as G11 glass epoxy laminate.

Because the target assembly is highly electrically biased during processing, it is necessary to completely cover it and to insulate it from accidental grounding by being touched by an operator or another piece of processing equipment. Therefore the upper insulator 117 has a downward projecting insulating skirt 120 which overlaps the upward projecting insulating skirt 137 of the outer insulator 134 thereby providing a complete cover around the edge of the target assembly. The outer insulator 134 and the upper insulator 117 can be constructed of a variety of plastics, for example, acrylic or polycarbonate.

As shown in Fig. 27, a rough vacuum connection is routed at the edge and around the process chamber 138 to the top chamber 114 via a rough vacuum passage 156 attached to the outer insulator 134. The magnet sweep mechanism and sensors (not shown) are separately connected and mounted to the top chamber cap 113.

The top chamber cap 113 is supported and sealed against the upper insulator 117 and located by a small flange around the upper insulator's perimeter. A movable magnet 116 (Fig. 25) is manipulated by a magnet sweep device (not shown) to move the magnet to magnetically assist sputtering according to the sweep path of the device. When the processing chamber 138 is evacuated to process conditions (approximately 10⁻⁸ torr) and the top chamber 114 enclosed by the cover 113 is evacuated to a rough vacuum (e.g. 1 torr), there will be only approximately 1 torr of differential pressure across the target assembly plate. A differential pressure of 1 torr across a target assembly plate having an area of 1 sq. meter will provide a force of approximately 30 lbs. or 13.6 kg on the whole of the plate. Compare this to approximately 22,780 lbs. or 10,330 kg force that would be experienced if the pressure in the cap were to remain at approximately 1 atmosphere. A force of approximately 23,000 lbs. on a thin target assembly would provide a substantial deflection at the center of the target while in comparison a force of approximately 30 lbs. over the target, even for a relatively thin and large target, would have very little effect. Even at pressures of up to 10 torr in the top chamber, the pressure applied to and thus the deflection of the target assembly is significantly reduced from those produced by atmospheric pressure. If the pressures in the two chambers 114 and 138 were equal, there would be no differential pressure across the target at all.

The process chamber 138 and top chamber cap 113 are both initially connected to a rough vacuum (∼1 torr) system). When the pressure limits of the rough vacuum subsystem are reached, the process chamber 138 is isolated and a cryogenic vacuum pump is activated to bring the process chamber pressure down to 10⁻⁹ torr or less. Inert gas, e.g. argon, is then introduced to bathe the substrate and target in argon at a pressure of approximately 10⁻³ torr. The top chamber 114 continues to be connected to the rough vacuum system. Conventional methods of increasing and decreasing the pressure differential between chambers can be used to raise or lower the differential. The sputtering target is provided with a back-up (dual seal) sealing means. Vacuum is pulled in the cavity formed by the primary vacuum seal and its back-up seal (differentially pumped seal) in order to improve vacuum pumping of the process chamber. A double seal system is employed to assure a tight seal around the processing chamber 138 and to minimize gas diffusion through the seals. As can be seen in Figure 27, the rough vacuum system is connected to and passes through the process chamber housing rough vacuum passage 156. The outer insulator 134 vacuum passage includes a between seal vacuum passage 140 to depressurize (to the rough vacuum pressure) the space between the O-ring seals around the ceramic (lower) insulator 133. Two 0.09 in. (2.3 mm) holes, for example, can be used for the seal vacuum passage 140. The possibility of undesired sputtering in this passage to the charged target assembly is nearly eliminated by the insulating properties of the polycarbonate outer insulator 134.

If the erosion of the target due to sputtering is uneven and the center of the target erodes more quickly than the perimeter, as it does according to many magnet sweep patterns, the pressure under the top chamber cap 113 can be adjusted to deliberately control the deflection in the center of the target assembly so that the distance between the object being sputter deposited and the target surface remains generally constant to provide more uniform deposition across the surface of the substrate to be sputter coated.

A power connection 155 for the target assembly 124 is configured to intimately connect with the target backing plate through the power connection hole 92 in the top of the target assembly 124. The upper insulator 117 surrounds top chamber cap 113.

A power connection for the target plate assembly 155 is configured to intimately connect with the target backing plate in the target assembly 124 through the power connection hole 92. The upper insulator 117 surrounds the top chamber cap 113, defining the top chamber 114 above the target assembly 124.

### Advantages

The target assembly is doubly sealed such that a vacuum may be pulled from both the side of the process chamber and the side of the magnetron chamber. The process/deposition parameters such as magnetron electrical impedance, substrate film thickness uniformity, etc. can be controlled somewhat using two chambers. The target assembly deflection can be controlled by varying the pressure between the two chambers. The target configuration as described provides no welds or other joints separating the cooling passages from the process chamber. The joints exposed to vacuum are so exposed only on the non-process side of the target assembly and therefore the possibility of leaks through defects in joints directly affecting the process side are eliminated. The sputtering target assembly and its cooling system are self-contained and upon replacement or removal of the target assembly, there is no water dripping or contamination of the sputtering chamber since its design consists of a self-contained heat exchanger unit. When the cooling fluid passing through its passages is at a temperature higher than the surroundings, the target assembly is warmed to reduce or accelerate out-gassing of the target (reducing this effect during processing, and eliminating condensation on the surface of the target assembly surfaces). The coolant-to-vacuum seals in this configuration is only performed in an area where a gasket is tightly held by a threaded fastener and the gas opening allowing gas trapped in the space of the screw fastener joints will also immediately cause liquid leaking in to the equalizing chamber to degrade the vacuum noticeably such that monitoring of such possible leakage is easily monitored automatically in any of these configurations. A sputtering target assembly of this configuration can be of a large size and a low profile. Such an assembly even if much larger than the current design, will deflect negligibly under vacuum applied from both sides.

The target assembly, in its present target size of 510mm x 620mm, or 570 x 720, however, does not require the top chamber to be under vacuum for the system to operate properly because the deflecting loads due to vacuum from the process-side chamber are small and the coolant loads are all internal to the target assembly.

The advantages of this device over the prior art include, once assembled, a one-piece target assembly which is interchangeable with other target assemblies without the danger of any cooling liquid being spilled into the sputtering-processing chamber. When large areas are to be sputtered which require larger processing and magnetron/pressure equalizing chambers, the deflection of the target assembly due to pressure differential across the target assembly is controlled or eliminated. The pressure of cooling liquid in the assembly is contained in the cooling passages by various securing techniques, including adhesive gluing the target backing plate to the cover plate or by various diffusion bonding techniques, brazing with or without mechanical fastening assistance. When properly done, there is virtually no possibility of coolant leakage in spite of the fact that differential pressure through and across the cooling passages is expected to reach several atmospheres when the cooling fluid is pressurized. Heat exchanger coolant passages can easily be re-designed to optimize the cooling temperature distribution as desired and based on empirical data. Another advantage of the thin planar laminated target of the invention is that the magnetron magnets can be scanned relatively closely to the target. Thereby, lower strength magnets can be used and their magnetic field shapes can be more flexibly tailored.

While the invention has been described with regard to specific embodiments, those skilled in the art will recognize that changes can be made in form and detail without departing from the spirit and scope of the invention. For example, the evaluations described here are merely representative of the invention and should not be considered to limit the scope of the invention to the method or structure herein described.

## Claims

1. A sputtering target assembly comprising:
a sputtering target in intimate contact with a first side of a backing plate forming part of a target backing plate assembly;
said target backing plate assembly configured to cover an opening of a sputtering chamber so as to seal the opening, said backing plate assembly having heat exchange fluid passages therethrough, said heat exchange fluid passages having one or more inlet and outlet openings,
wherein the target backing plate assembly comprises said backing plate and a cooling cover plate, said backing plate having a second side, said cooling cover plate having a third side, said third side being fluid tightly joined to said second side, grooves being formed in at least one of said second and third sides to form heat exchange cooling passages between said target backing plate and said cooling cover plate,
wherein a bond is formed between said second side of said cooling cover plate and said third side of said backing plate through a gasketed connection including at least one or more gaskets and one or more fasteners compressing said one or more gaskets, said gasketed connection forming a generally fluid tight seal between said second and said third sides surrounding said heat exchange cooling passages, and forming a generally fluid tight seal surrounding each of said one or more fasteners securing a field of said cooling cover plate within the inside perimeter of a portion of said gasketed connection providing said generally fluid tight seal between said second and said third sides surrounding said heat exchange cooling passages.

2. The sputtering target assembly as in Claim 1, wherein said second side is generally planar and said third side is generally planar.

3. The sputtering target assembly as in Claim 1, wherein a portion of the surface of said second and third sides facing said cooling passages have received a surface treatment to substantially roughen the surface.

4. The sputtering target assembly as in Claim 1, wherein one or more of said one or more gaskets are die cut.

5. The sputtering target assembly as in Claim 4, wherein said at least more or more gaskets includes a single die cut sheet of gasket material to form said generally fluid tight seal between said second and said third sides surrounding said heat exchange cooling passages and said generally fluid tight seal surrounding each of said one or more fasteners securing said field of said cooling cover plate within the inside perimeter of a portion of said gasketed connection.

6. A sputtering target assembly as in Claim 1,
wherein said target backing plate assembly on a side opposite its target side is configured to receive and seal an opening of a pressure equalizing chamber facing said side opposite its target side, such that when the target assembly is sealed to both the opening of the sputtering chamber and the opening of the pressure equalizing chamber the sputtering target assembly may act as a diaphragm type barrier between the sputtering chamber and the pressure equalizing chamber.

7. A sputtering target assembly as in Claim 6,
wherein said one or more inlet and outlet openings are located so that they are not exposed to the pressures inside said sputtering chamber or said pressure equalizing chamber.

8. The sputtering target assembly as in Claim 1, for a sputtering apparatus including a sputtering chamber having a sputtering opening having an inside perimeter pattern, a first side of the sputtering target assembly is sealed against the opening outside the pattern and including a pressure equalizing chamber sealed to a second side of said sputtering target assembly generally opposite the location where the target assembly is sealed on the first side, the target assembly acting as a diaphragm type barrier between the sputtering chamber and the pressure equalizing chamber,
wherein said inlet and outlet openings are located in said backing plate outside a pattern formed on said backing plate by projecting the pattern of the inside perimeter of the sputtering opening on the backing plate when said backing plate is sealed against the opening.

9. A sputtering target assembly for a sputtering apparatus including a sputtering chamber having a sputtering opening having an inside perimeter pattern, a first side of the sputtering target assembly is sealed against the opening outside the pattern and including a pressure equalizing chamber sealed to a second side of said sputtering target assembly generally opposite the location where the target assembly is sealed on the first side, the target assembly acting as a diaphragm type barrier between the sputtering chamber and the pressure equalizing chamber comprising:
a sputtering target in intimate contact with a first side of a backing plate forming part of a target backing plate assembly;
said target backing plate assembly having heat exchange fluid passages therethrough, said heat exchange fluid passages having one or more inlet and outlet openings,
wherein the target backing plate assembly comprises said backing plate and a cooling cover plate, said backing plate having a second side, said cooling cover plate having a third side fluid tightly joined to said second side, grooves being formed in at least one of said second and third sides to form heat exchange cooling passages between said target backing plate and said cooling cover plate,
wherein a bond is formed between said second side of said cooling cover plate and said third side of said backing plate through a gasketed connection including at least one or more gaskets and one or more fasteners compressing said one or more gaskets, said gasketed connection forming a generally fluid tight seal between said second and said third sides surrounding said heat exchange cooling passages, and forming a generally fluid tight seal surrounding each of said one or more fasteners securing a field of said cooling cover plate within the inside perimeter of a portion of said gasketed connection providing said generally fluid tight seal between said second and said third sides surrounding said heat exchange cooling passages.

10. The sputtering target assembly as in Claim 9, wherein said second side is generally planar and said third side is generally planar.

11. The sputtering target assembly as in Claim 9, wherein a portion of the surface of said second and third sides facing said cooling passages have received a surface treatment to substantially roughen the surface.

12. The sputtering target assembly as in Claim 1,
wherein said heat exchange fluid passages include a set of fins configured to generally separate adjacent cooling passages,
wherein an end of said at least one said fins is configured to receive at least one of said one or more fasteners and compress at least one of said one or more gaskets to prevent leakage of heat exchange fluid through an opening in the plate clamped to said fin end by said at least one of said one or more fasteners.

13. The sputtering target assembly as in Claim 12,
wherein an end of a second of said at least one of said fins is in contact with the surface of the plate clamped to said fin end by said at least one of said one or more fasteners, wherein when such contact is made a gasket space having a predefined compressed gasket thickness dimension is present between opposed sealing surfaces of said backing plate and said cooling cover plate and such contact generally prevents compression of said one or more gaskets located in said gasket space beyond said predefined compressed gasket thickness dimension by said one or more fasteners.

14. The sputtering target assembly as in Claim 1,
wherein said heat exchange fluid passages are configured in a serpentine path.

15. The sputtering target assembly of Claim 14, wherein said inlet openings and said outlet opening to said cooling path are at the same end of the target backing plate assembly.

16. The sputtering target assembly of Claim 6, wherein an opening for receiving a fastener in said cooling cover plate to urge said cooling cover plate toward said backing plate within said field of said cooling cover plate includes a fastener receiving bearing surface through which a head of said fastener contacts said cooling cover plate, wherein said fastener and said head are configured so that at least one of either said fastener receiving bearing surface and said head of said fastener form at least one fluid passage between a surface of a fourth side of said cooling cover plate and said fastener receiving opening of said cooling cover plate, wherein said fourth side of said cooling cover plate is opposite said third side of said cooling cover plate.

17. The sputtering target assembly of Claim 16, wherein each of said openings for receiving a fastener in said cooling cover plate to urge said cooling cover plate toward said backing plate within said field of said cooling cover plate include a fastener receiving bearing surface through which a head of said fastener contacts said cooling cover plate, wherein said fastener and said head are configured so that at least one of either said fastener receiving bearing surface and said head of said fastener form at least one fluid passage between a surface of a fourth side of said cooling cover plate and said fastener receiving opening of said cooling cover plate, wherein said fourth side of said cooling cover plate is opposite said third side of said cooling cover plate.
